Europäisches Patentamt

European Patent Office

Office européen des brevets

(19)

(11) **EP 1 426 982 A1**

(12) **EUROPEAN PATENT APPLICATION**
published in accordance with Art. 158(3) EPC

(43) Date of publication:
**09.06.2004 Bulletin 2004/24**

(51) Int Cl.⁷: **H01F 1/00**, H01F 10/16, H01Q 17/00, C22C 38/00, H05K 9/00

(21) Application number: **02762867.6**

(22) Date of filing: **27.08.2002**

(86) International application number:
**PCT/JP2002/008603**

(87) International publication number:
**WO 2003/021610 (13.03.2003 Gazette 2003/11)**

(84) Designated Contracting States:
FI SE

(30) Priority: **31.08.2001 JP 2001263486**

(71) Applicant: **TDK Corporation
Chuo-ku, Tokyo 103-8272 (JP)**

(72) Inventors:
• **TASAKI, Kazunori c/o TDK CORPORATION
Chuo-ku, Tokyo 103-8272 (JP)**
• **IIJIMA, Yasushi c/o TDK CORPORATION
Chuo-ku, Tokyo 103-8272 (JP)**
• **KAKINUMA, Akira c/o TDK CORPORATION
Chuo-ku, Tokyo 103-8272 (JP)**
• **WAKAYAMA, Katsuhiko
c/o TDK CORPORATION
Chuo-ku, Tokyo 103-8272 (JP)**

• **HASHIMOTO, Yasuo c/o TDK CORPORATION
Chuo-ku, Tokyo 103-8272 (JP)**
• **CHOU, Tsutomu c/o TDK CORPORATION
Chuo-ku, Tokyo 103-8272 (JP)**
• **KAYA, Masanori c/o TDK CORPORATION
Chuo-ku, Tokyo 103-8272 (JP)**
• **ISHIKAWA, Hiroyasu c/o TDK CORPORATION
Chuo-ku, Tokyo 103-8272 (JP)**
• **YAMASHITA, Shinichi c/o TDK CORPORATION
Chuo-ku, Tokyo 103-8272 (JP)**

(74) Representative: **HOFFMANN - EITLE
Patent- und Rechtsanwälte
Arabellastrasse 4
81925 München (DE)**

(54) **LAMINATED SOFT MAGNETIC MEMBER&comma; SOFT MAGNETIC SHEET AND PRODUCTION METHOD FOR LAMINATED SOFT MAGNETIC MEMBER**

(57)     A laminated soft magnetic member 5, which comprises a laminated body in which 1 μm or less thick soft magnetic metal layer 7 and an insulating layer 6 are laminated alternately and is 0.2 mm or less in overall thickness, is excellent in permeability in the high frequency band exceeding 800 MHz, and accordingly, by being attached to a cellular phone, can improve the radiation efficiency of the electromagnetic wave on the side opposite to the head of a human body and is preferable as a member for the countermeasure against SAR.

FIG. 3

EP 1 426 982 A1

**Description**

Technical Field

The present invention relates to a laminated soft magnetic member which can be installed and used in a portable electric appliance such as a cellular phone, and particularly relates to a laminated soft magnetic member which has high permeability in the frequency band ranging from 800 MHz to 3 GHz and can improve the radiation efficiency of the electromagnetic wave emitted from a portable electric appliance.

Background Art

Cellular phones have been year by year reduced in size and weight, and accordingly when a cellular phone is used, the position of the antenna thereof is located very closely to the human body, more specifically, to the head. In this case, the properties of the antenna are affected by the human body, and thus the performance of the antenna tends to be degraded. In other words, the electric power loss, caused by the partial absorption by the human body of the electromagnetic wave radiated by the antenna, leads to the lowering of the receiving sensitivity and the reduction of the operation life of the battery.

On one hand, the absorption of electromagnetic wave by the human body is increasing, and hence the adverse effect thereof on the human body is apprehended. Accordingly, the guidelines on the specific absorption are enacted in some countries including Japan. As the evaluation quantity of the specific absorption defined in the guidelines of the specific absorption in these countries, the SAR (specific absorption rate) defined by the following formula is adopted:

$$SAR = \sigma E^2/2\rho$$

(E: the electric field entering into a human body, $\sigma$: the permittivity of the human body tissue, $\rho$: the density of the human body tissue)

Accordingly, a method has been proposed in which a low loss magnetic plate is arranged near the antenna as a method for reducing the SAR while improving the efficiency of the electromagnetic wave radiation from a cellular phone, namely, the radiation efficiency. However, in a method applying a magnetic plate made of a composite material composed of a fine magnetic powder and a resin, the improvement of radiation efficiency is still as small as 0.6 dB even with a plate thickness of 5 mm. For the purpose of meeting the reduction in size and weight of cellular phones, the plate thickness is made to be preferably 0.2 mm or less, more preferably 0.1 mm or less. In other words, it is difficult to apply the low loss magnetic plate to the cellular phone.

The electromagnetic interference (EMI) as another problem in the cellular phone has been growing. As a material excellent in the noise absorption properties in the high

frequency region exceeding 1 GHz, composite soft magnetic members have been proposed in which a soft magnetic metal powder is dispersed in a resin or a rubber; for example, a composite magnetic material has been proposed in which a soft magnetic flaky Fe-Si alloy powder is oriented and arranged in a rubber or a resin (Japanese Patent Laid-Open No. 9-35927, "Kogyo Zairyou (Industrial Materials), pp. 31 to 35, pp. 36 to 40, etc., October, 1998).

As a member serving as a countermeasure to deal with the improvement of radiation efficiency and SAR in the cellular phone, the above described composite soft magnetic member can be attached to the inside or the exterior of a cellular phone housing; however, the aforementioned composite soft magnetic member has low permeability, for example, in the high frequency band ranging from 800 MHz to 3 GHz, and hence it is hardly possible to obtain desired properties with the member thickness of 0.2 mm or less.

Thus, the present invention aims to provide a soft magnetic member which has excellent permeability in the high frequency band exceeding 800 MHz even with the member thickness of 0.2 mm or thinner. The present invention also provides a production method capable of suitably yielding such a soft magnetic member. Furthermore, the present invention provides a soft magnetic sheet suitable for use in such a soft magnetic member.

Disclosure of the Invention

Conventional composite soft magnetic members have, as described above, structures in which soft magnetic metal powders are mixed and dispersed in insulator matrixes of rubbers, resins and the like. In this case, a diamagnetic field comes to be generated in the soft magnetic metal powders dispersed in the matrixes. Soft magnetic metal powders are mainly produced by means of the water atomizing method, and hence the stress remains even with a heat treatment conducted thereafter. Accordingly, the conventional composite soft magnetic members are poor in permeability in the high frequency band exceeding 800 MHz.

In these circumstances, the present inventors investigated the lamination of a plurality of layers made of a soft magnetic metal with insulating layers interposed therebetween, instead of the dispersion of a soft magnetic metal powder as in the conventional composite soft magnetic members. Thus, the present inventor has come to confirm that by obtaining a sheet wherein a soft magnetic metal film is formed on a resin film by means of plating or the like, and by laminating the sheets thus obtained, a laminated soft magnetic member of 0.2 mm or less in thickness can be obtained, and this laminated soft magnetic member exhibits a higher permeability than those of the conventional composite soft magnetic members in the high frequency band exceeding 800 MHz.

Accordingly, the present invention provides a laminated soft magnetic member composed of a laminated body in which an insulating layer and a 1 μm or less thick soft magnetic metal layer are alternately laminated, and the overall thickness of the member is 0.2 mm or less.

It is preferable that in the laminated soft magnetic member of the present invention, the thickness of the soft magnetic metal layer is 0.5 μm or less.

Additionally, it is preferable that in the laminated soft magnetic member of the present invention, the soft magnetic metal layer is composed of a soft magnetic alloy in which one or more of Fe, Ni and Co are the main components.

Furthermore, it is preferable that in the laminated soft magnetic member of the present invention, the insulating layer is composed of a resin layer of 50 μm or less in thickness, preferably 25 μm or less, more preferably 10 μm or less. In this connection, the resin layer can be composed of the resins such as polyimide, polyamide and polyethylene terephthalate (PET).

Additionally, in the laminated soft magnetic member of the present invention, the insulating layer can be composed of a resin layer subjected to heat fusion bonding (heat fusion bonded layer). The thickness in this case can also be made to be, similarly to the resin layer, 50 μm or less, preferably 25 μm or less, more preferably 10 μm or less. In particular, the heat fusion bonded layer is advantageous in that its layer thickness can be made as thin as 1.0 μm or less by means of coating, spraying and other techniques. Additionally, the insulating layer can also be composed of a thermo-compression bonded resin layer.

It is effective that in the laminated soft magnetic member of the present invention, a metal sublayer is interposed between the insulating layer and the soft magnetic metal layer. The metal sublayer functions as a conductive layer when the soft magnetic metal layer is formed by electroplating, and additionally can increase the ferromagnetic resonance frequency in the GHz band through the selection of the material thereof. The ferromagnetic resonance frequency is proportional to the square root of the product between the saturation magnetization and the anisotropic magnetic field. The effect can be beneficially obtained through increasing the magnetoelastic energy and anisotropic magnetic field through a combination of the soft magnetic metal layer and metal sublayer different from each other in magnetostriction sign, and through increasing the anisotropic magnetic field of the soft magnetic metal layer through magnetic coupling between the metal sublayer large in magnetic anisotropy and the soft magnetic metal layer.

In the laminated soft magnetic member of the present invention, an oxide layer can be formed either on the surface of the soft magnetic metal layer or on the surface of the metal sublayer. The presence of the oxide layer is expected to reduce the eddy current and to improve the anisotropic magnetic field.

Furthermore, in the laminated soft magnetic member of the present invention, an insulating layer and a conductor layer can be alternately laminated on either surface of the laminated body. The use and appropriate arrangement of this form of laminated soft magnetic member makes it possible to improve the gain.

The present invention provides a soft magnetic sheet suitable for the laminated soft magnetic member. More specifically, the soft magnetic sheet of the present invention is characterized in that the sheet comprises a 50 μm or less thick insulating resin film, a 1 μm or less thick soft magnetic metal layer formed by plating on the insulating resin film, and a metal sublayer composed of a metal larger in coercive force or anisotropic magnetic field than the metal composing the soft magnetic metal layer, and interposed between the insulating resin film and the soft magnetic metal layer. Lamination of this type of soft magnetic sheets makes it possible to obtain the laminated soft magnetic member of the present invention.

In the soft magnetic sheet of the present invention, the metal sublayer and the soft magnetic metal layer can be formed both on the front surface and on the back surface of the insulating resin film.

It is preferable that in the soft magnetic sheet of the present invention, the soft magnetic metal layer is composed of a Fe-Ni system alloy with the Fe content of 20 to 80 wt%, moreover 30 to 70 wt%, or a soft magnetic alloy in which the saturation flux density is 1 T or more and the mangetostriction is positive. In case that the magnetostriction of the soft magnetic metal layer is positive, the base film expands and contracts along the opposite direction, when a magnetic field applied, to efficiently increase the anisotropy due to the magnetoelastic effect, and hence it is preferable that the magnetostriction of the metal sublayer is made negative.

The present invention provides the following production method suitable for obtaining the laminated soft magnetic member. More specifically, the production method of the laminated soft magnetic member of the present invention is characterized in that the method comprises a step (a) for producing a sheet body in which a 1 μm or less thick soft magnetic metal layer is formed on a 50μm or less thick insulating resin film, and a step (b) in which the sheet body is laminated in such a way that the insulating resin layer and the soft magnetic metal layer are arranged alternately. In the production method of the laminated soft magnetic member, a plurality of sheet bodies can be produced in the step (a) , and the plurality of sheet bodies can be laminated in such a way that the insulating resin film and the soft magnetic metal layer are arranged alternately. In this connection, a step (c) can be added in which the laminated bodies obtained by the step (b) are heated at a temperature equal to or higher than the softening temperature of the insulating resin layer and bonded by compression. Additionally, in the step (a) a strip-like sheet body can be produced, and in the step (b) lamination can be conducted by winding the strip-like sheet body in such a way that the insulating resin film and the soft magnetic metal layer are arranged alternately.

In the production method of the laminated soft magnetic member of the present invention, a stress relief annealing can be applied to the obtained laminated body.

Additionally, the present invention provides the following production method suitable for obtaining the laminated soft magnetic member. This method is a production method of the laminated soft magnetic member which is characterized in that the method comprises a step (d) in which a 1 μm or less thick soft magnetic metal layer is formed on a film, a step (e) in which a resin layer for the purpose of heat fusion bonding is formed on the surface of the soft magnetic metal layer on which the film is not formed, a step (f) for obtaining, by peeling off the film, a sheet body in which the soft magnetic metal layer and the resin layer are laminated, and a step (g) in which the sheet body is laminated in such a way that the soft magnetic metal layer and the resin layer are arranged alternately.

In the production method of the laminated soft magnetic member, in the step (f) a plurality of sheet bodies can be produced and in the step (g) the plurality of sheet bodies can be laminated in such a way that the resin layer for heat fusion bonding and the soft magnetic metal layer are arranged alternately. Additionally, in the step (f) a strip-like sheet body can be produced, and in the step (g), by winding one or more sheets of the strip-like sheet bodies, lamination can be conducted in such a way that the resin layer and the soft magnetic metal layer are arranged alternately.

Furthermore, the present invention provides the following production method suitable for obtaining the laminated soft magnetic member. The production method is characterized in that the method comprises a step (h) for producing a plurality of sheet bodies in which 1 μm or less thick soft magnetic metal layer is formed both on the front surface and on the back surface of a 50 μm or less thick first insulating resin film, and a step (i) in which the plurality of the above described sheet bodies are laminated through a intermediary of a second insulating resin film.

Brief Description of the Drawings

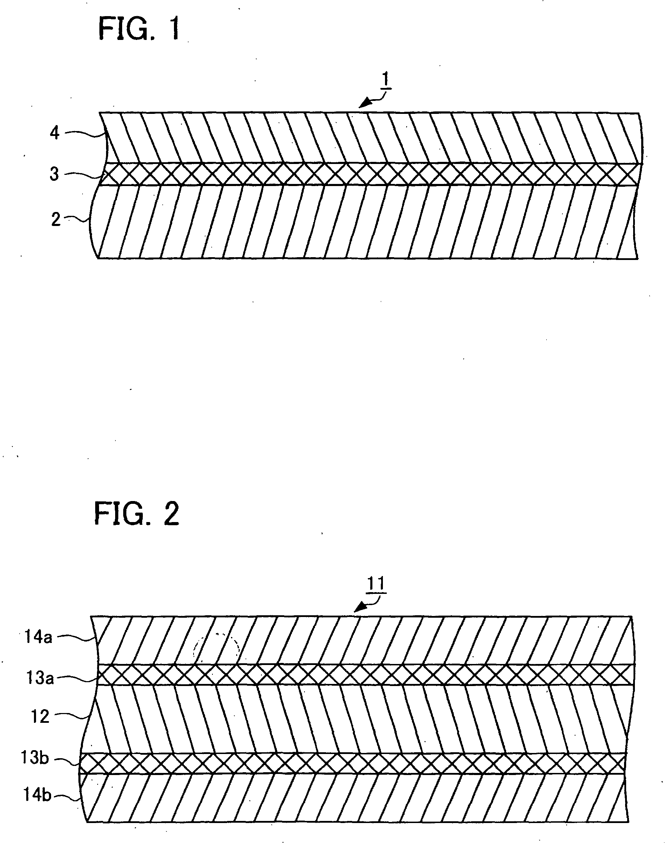

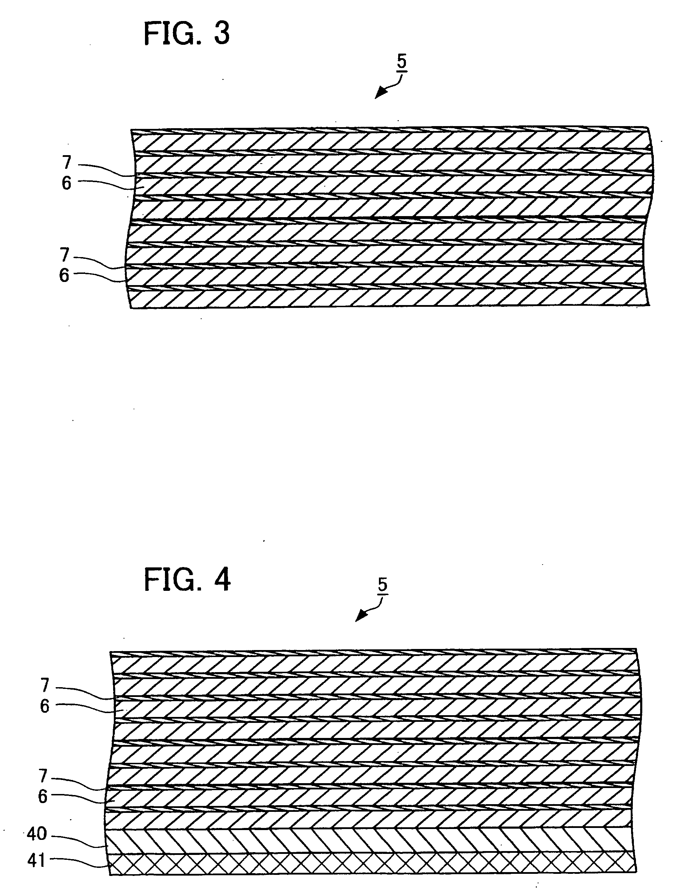

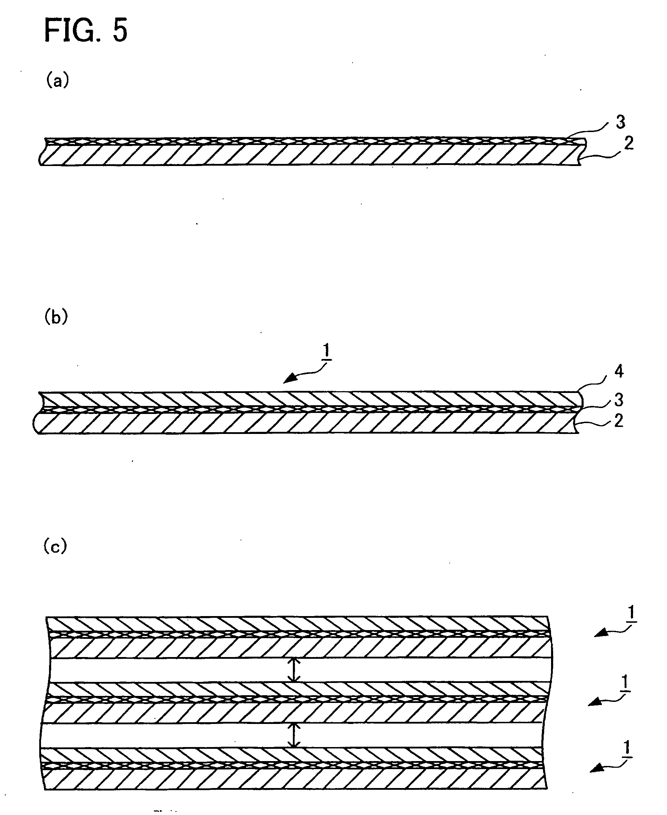

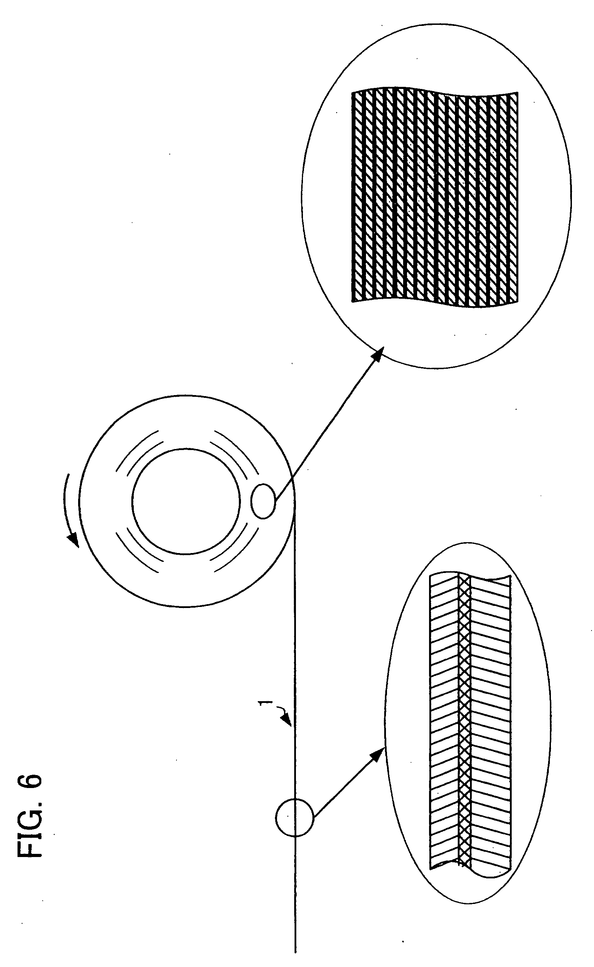

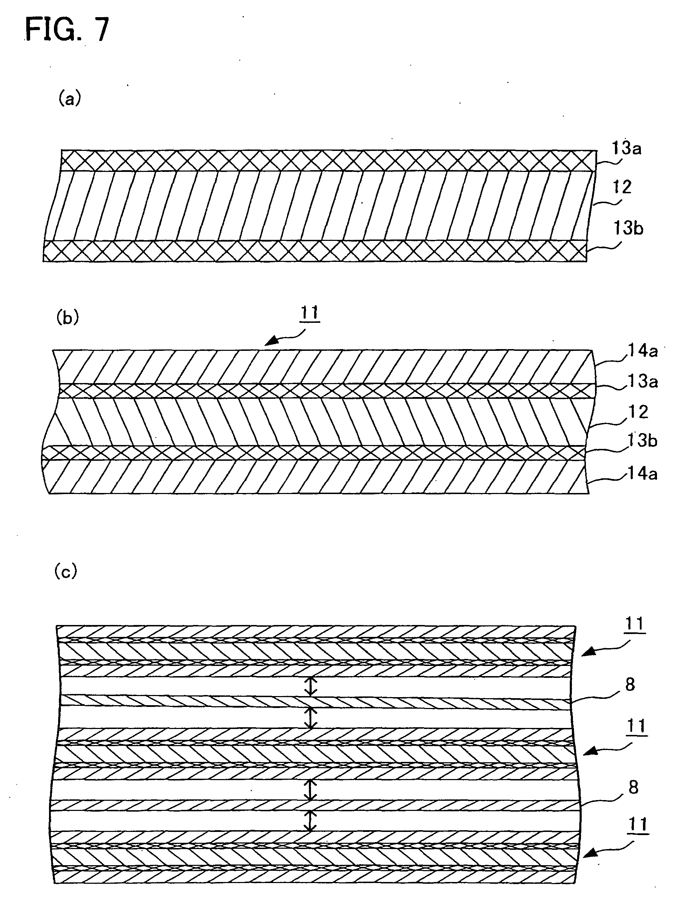

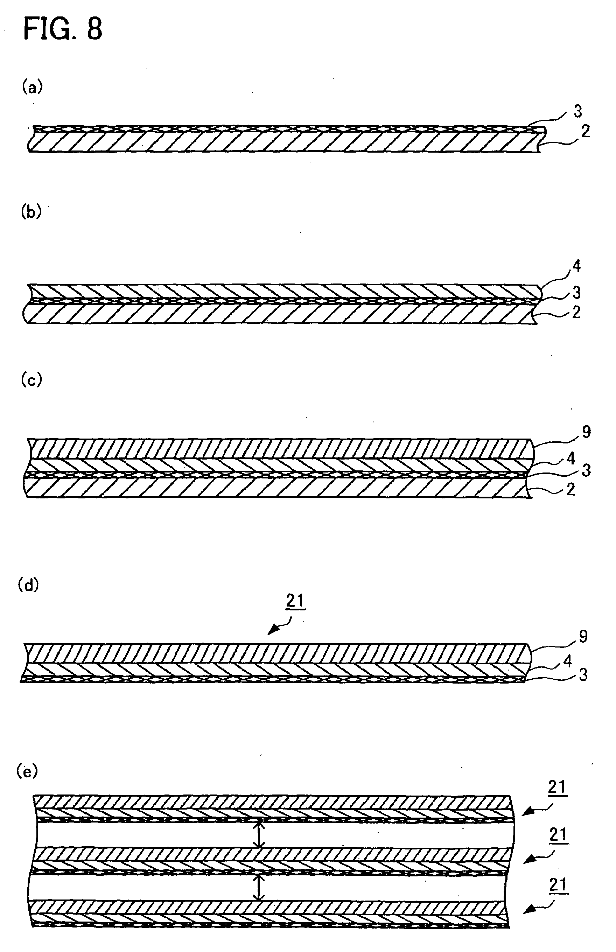

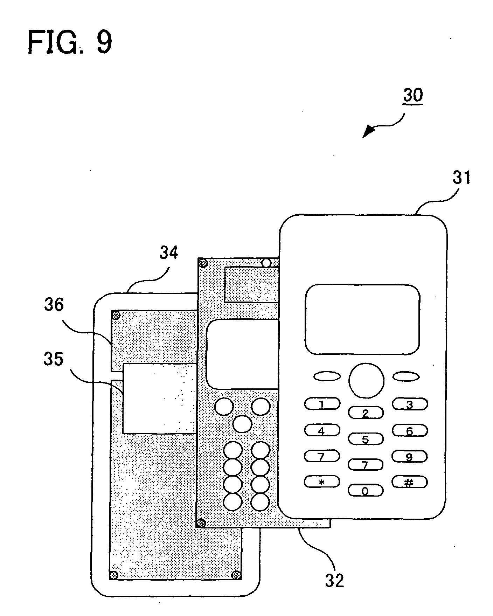

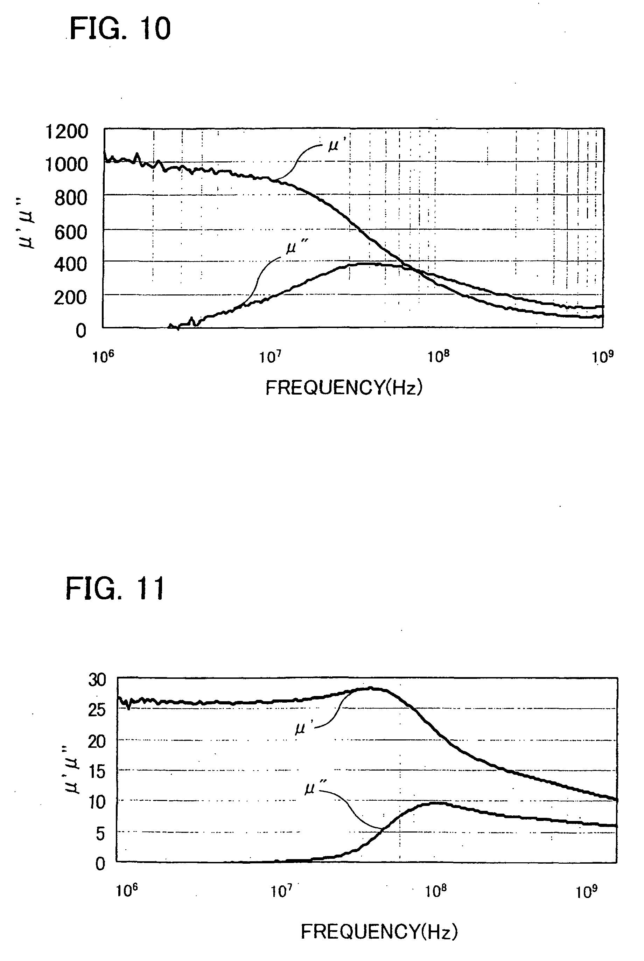

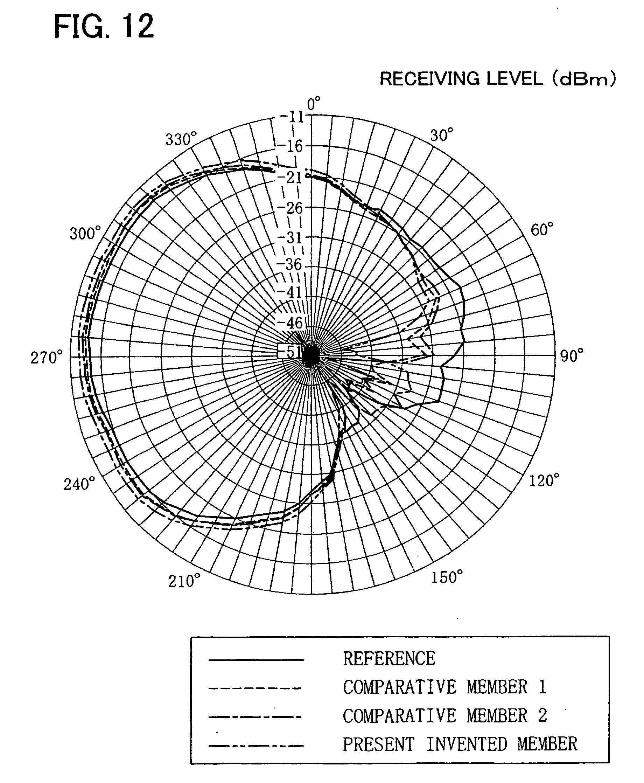

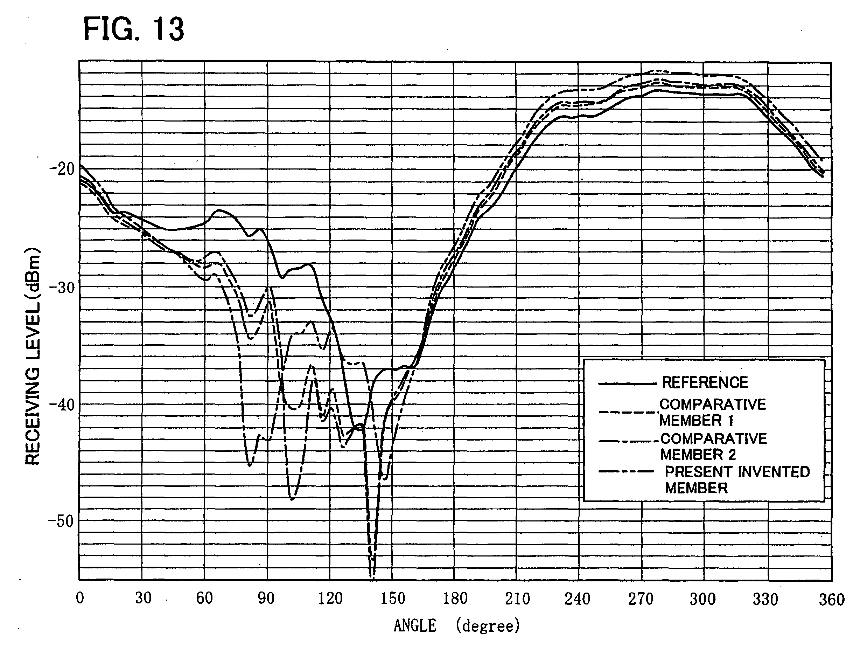

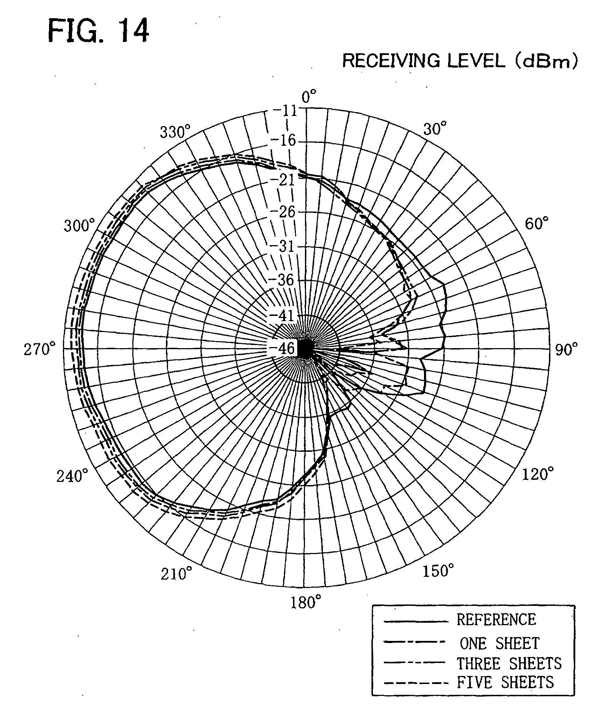

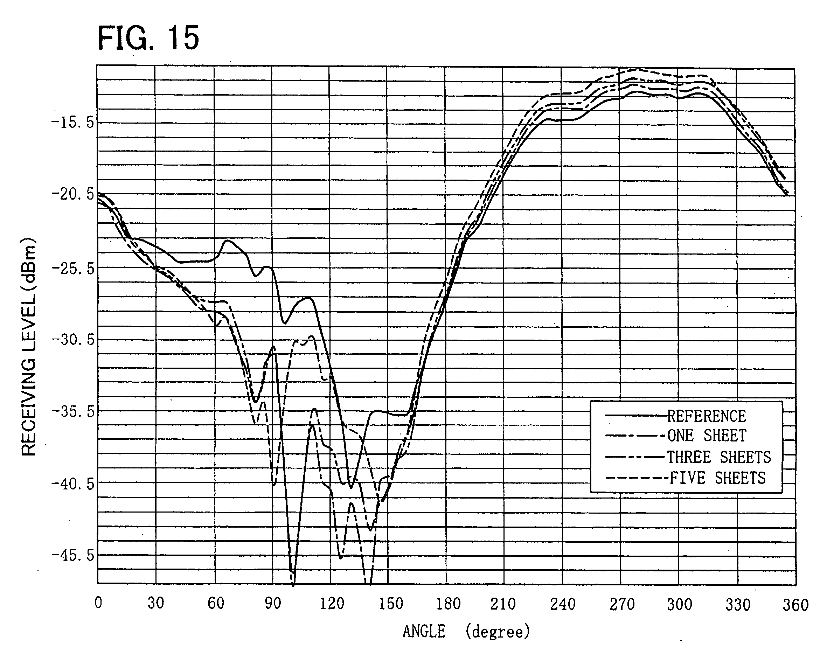

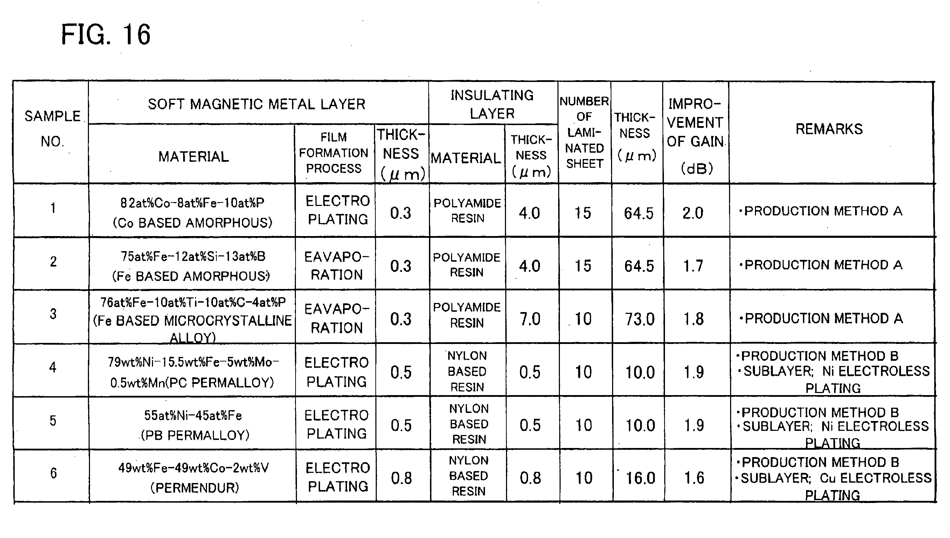

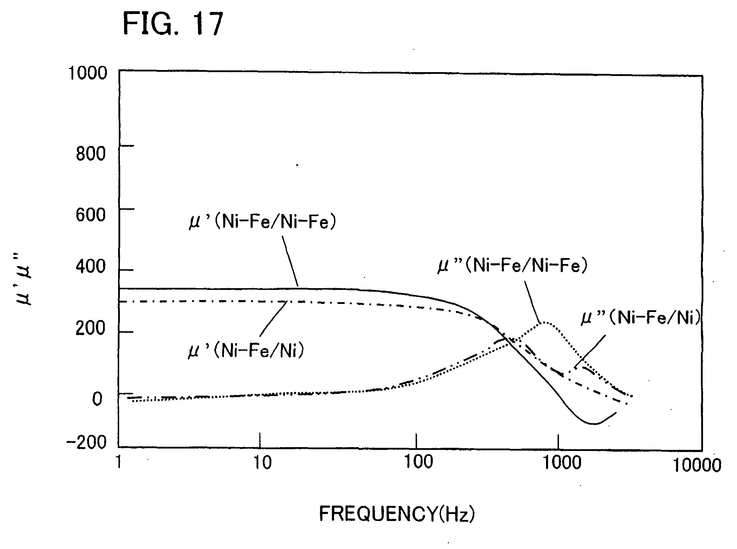

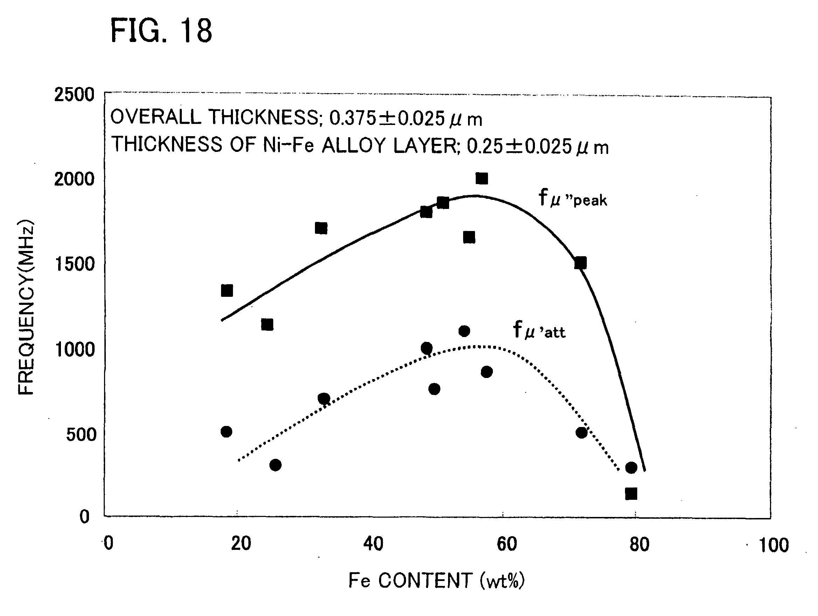

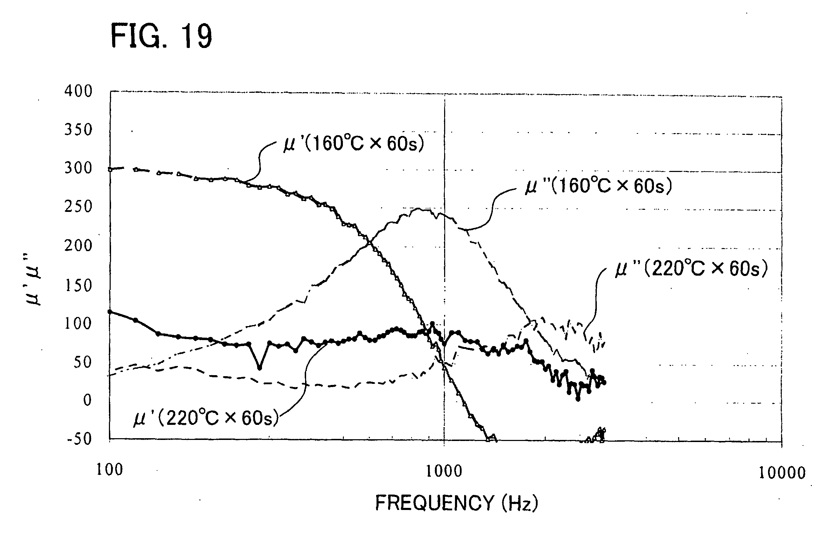

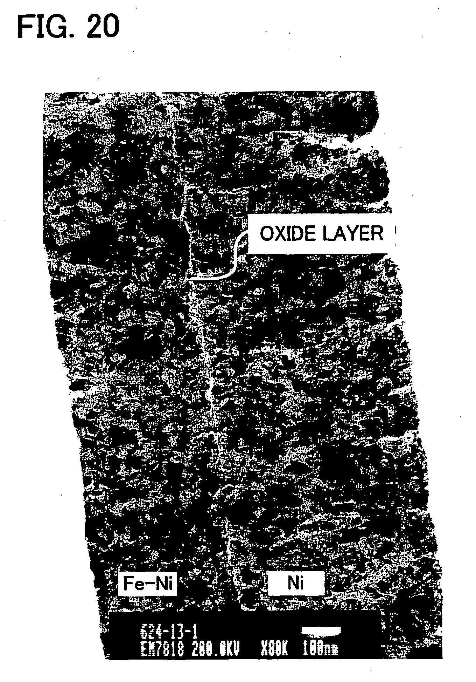

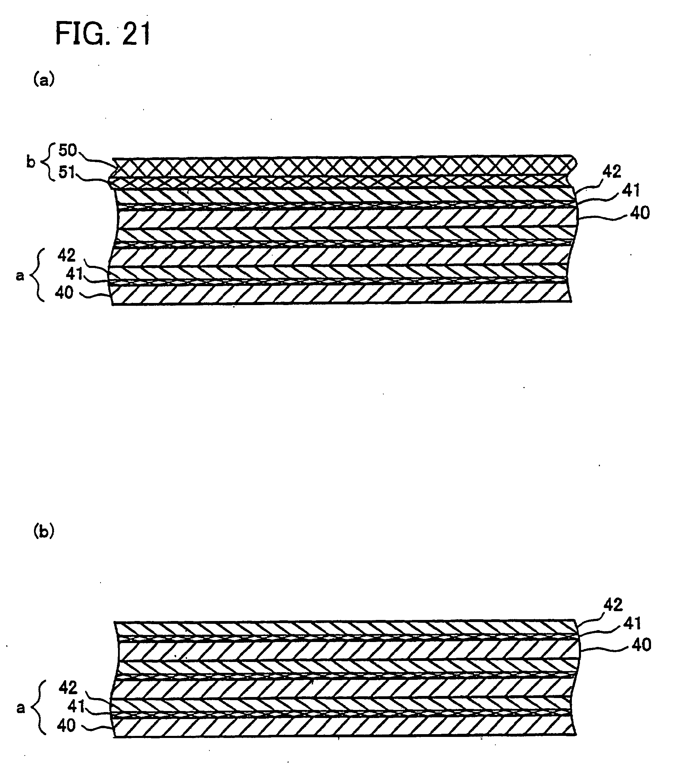

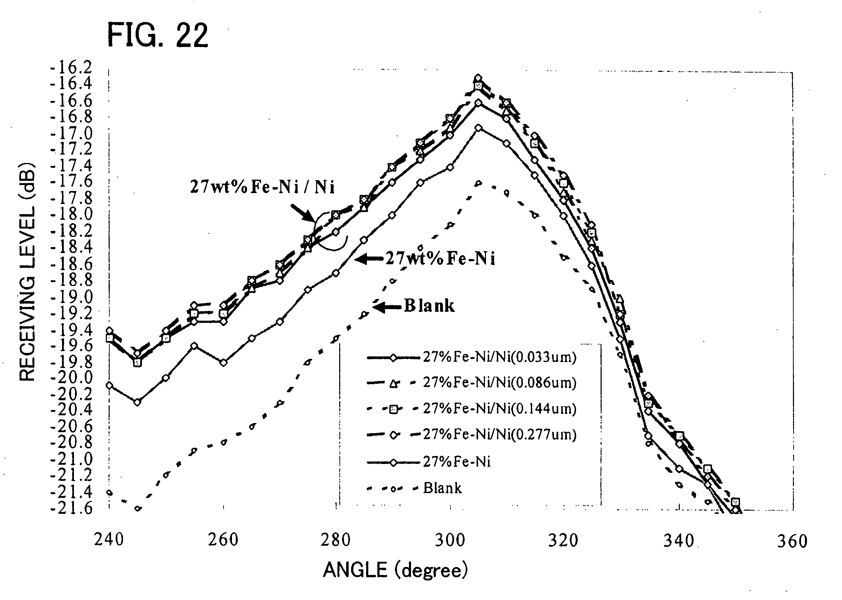

FIG. 1 is a sectional view illustrating one example of a soft magnetic sheet according to the present invention; FIG. 2 is a sectional view illustrating another example of a soft magnetic sheet according to the present invention; FIG. 3 is a sectional view illustrating one example of a laminated soft magnetic member according to the present invention; FIG. 4 is a sectional view illustrating another example of a laminated soft magnetic member according to the present invention; FIG. 5 is a diagram illustrating one example of a production method of a laminated soft magnetic member according to the present invention; FIG. 6 is a diagram illustrating another example of a production method of a laminated soft magnetic member according to the present invention; FIG. 7 is a diagram illustrating another example of a production method of a laminated soft magnetic member according to the present invention; FIG. 8 is a diagram illustrating another example of a production method of a laminated soft magnetic member according to the present invention; FIG. 9 is a schematic view illustrating a condition in which a laminated soft magnetic member according to the present invention is arranged in a cellular phone; FIG. 10 is a graph showing the frequency properties of the complex permeability of the laminated soft magnetic member obtained in Example 1; FIG. 11 is a graph showing the frequency properties of the complex permeability of a laminated soft magnetic member obtained in a conventional example; FIG. 12 is a graph showing the measurement results of the radiated electromagnetic fields in Example 2; FIG. 13 is a graph showing the measurement results of the radiated electromagnetic fields in Example 2; FIG. 14 is a graph showing the measurement results of the radiated electromagnetic fields in Example 2; FIG. 15 is a graph showing the measurement results of the radiated electromagnetic fields in Example 2; FIG. 16 is a diagram showing the specifications of the soft magnetic member adopted in Example 3; FIG. 17 is a graph showing the frequency properties of the complex permeabilities of the laminated soft magnetic members obtained in Example 4; FIG. 18 is a graph showing the relation between the Fe content in the soft magnetic metal layer and the resonance frequency in the laminated soft magnetic member obtained in Example 5; FIG. 19 is a graph showing the frequency properties of the complex permeability of the laminated soft magnetic member obtained in Example 6; FIG. 20 is a transmission electron microscope micrograph showing a sectional structure of the laminated soft magnetic member obtained in Example 7; FIG. 21 is a view illustrating the configurations of the laminated soft magnetic members used in Example 8; and FIG. 22 is a graph showing the measurement results of the radiated electromagnetic fields in Example 8.

Best Mode for Carrying Out the Invention

Description will be made below on the embodiments of the present invention.

<Soft magnetic sheet>

FIGS. 1 and 2 are partial sectional views showing examples of the soft magnetic sheets used in a laminated soft magnetic member of the present invention.

The soft magnetic sheet 1 shown in FIG. 1 is composed of a resin film 2, a metal sublayer 3 formed on the resin film 2, and a soft magnetic metal layer 4 formed on the metal sublayer 3.

As for the resin film 2, polyethylene, polypropylene, polystyrene, melamine resin, urea resin, phenolic resin, polyethylene terephthalate, polybutylene terephthalate, polysulfone, polycarbonate, polytetrafluoroethylene, polyamide, polyolefin, polyimide, fluorocarbon resin, and silicone resin can be used. Among these, resin materials having heat resistance are preferably used when a heat treatment is conducted, as described below, in the course of the production process of the laminated soft magnetic member.

The soft magnetic metal layer 4 can be composed of any of the transition metal elements exhibiting soft magnetism, or an alloy comprising a transition metal element and other metal elements. Specific examples of the corresponding alloys include an alloy in which one or more of Fe, Co and Ni are the main components such as an Fe-Ni system alloy, an Fe-Co system alloy and a Co-Ni system alloy. Among these alloys, an alloy having a saturation flux density of 1.0 T or more, moreover 1.5 T or more, is preferable. Particularly among these, an Fe-Ni alloy, an Fe-Co alloy and a Co-Ni-Fe alloy each with an Fe content of 20 to 80 wt% (preferably 30 to 70 wt%, more preferably 40 to 65 wt%) are preferable. Alloys having such a composition are high in saturation magnetization, and are advantageous in that the resonance frequency is shifted to the higher frequency side by increasing the anisotropic magnetic field through anisotropy control. These alloys can contain 15 at% or less of one or more of Nb, Mo, Ta, W, Zr, Mn, Ti, Cr, Cu and Co. Incidentally, when a soft magnetic metal layer 4 is formed by plating, such elements as C and S are inevitably contained, and the soft magnetic metal layer 4 of the present invention allows the presence of such elements contained.

As for the soft magnetic metal layer 4, either a crystalline alloy or an amorphous alloy can be used. As an amorphous alloy, Co based alloys and Fe based alloys can be used. Additionally, the present invention allows the use of Fe system microcrystalline alloys. A microcrystalline alloy is generally known as an alloy which is mainly composed of fine crystals of 10 nm or less in grain size.

The soft magnetic metal layer 4 can be produced by a variety of film formation processes including the plating (electrolytic or electroless) method, vacuum evaporation, sputtering and the like. These film formation processes can be applied each alone. Accordingly, the soft magnetic metal layer 4 can be formed either solely by plating or solely by deposition. Needless to say, a plurality of film formation processes can be combined. Plating is preferable for the present invention in that plating can form films at lower temperatures than the vacuum evaporation and sputtering methods. This is because in the present invention, the soft magnetic metal layer 4 is formed on a resin film 2, and hence it is preferable that no thermal effect is given to the resin film 2. Additionally, plating has a merit that plating can obtain a prescribed thickness of film in a shorter period of time as compared to the vacuum deposition and sputtering methods. Incidentally, when the soft magnetic metal layer 4 is obtained by plating, some elements such as S contained in the plating bath are mixed in the soft magnetic metal layer 4, and hence the soft magnetic metal layer 4 formed by plating is discriminable from the soft magnetic metal layers 4 formed by the other processes.

The metal sublayer 3 plays a role of a conductive layer becoming necessary when the soft magnetic metal layer 4 is formed by electroplating on the resin film 2. The metal sublayer 3 can be formed, for example, by the vacuum deposition method. Additionally, after the metal sublayer 3 has been formed by electroless plating, the soft magnetic metal layer 4 can be formed by electroplating. When soft magnetic metal layer 4 is formed by a method other than electroplating, the metal sublayer 3 can sometimes be omitted. In other words, the metal sublayer 3 is a optional element in the present invention. When a soft magnetic metal is used for the metal sublayer 3, the metal sublayer 3 comes to compose a part of soft magnetic metal layer 4.

It is preferable to select a material larger in coercive force than the soft magnetic metal layer 4 as the metal sublayer 3. By selecting in such a way, the anisotropic magnetic field of the soft magnetic metal layer 4 can be increased and the ferromagnetic resonance frequency in the GHz band can be made larger. Consequently, in the neighborhood of 2 GHz, the $\mu'$ (the real part of the complex permeability) can be increased and the $\mu''$ (the imaginary part of the complex permeability) can be reduced. In the frequency band which is used by the cellular phone, the larger $\mu'$ and the smaller $\mu''$, lead larger improvement of the radiation efficiency of electromagnetic wave. Improvement of permeability in the GHz band can also be expected when a layer made of a material similar to that of the metal sublayer 3 is formed on the soft magnetic metal layer 4.

Next, in the soft magnetic sheet 1, the thickness of the resin film 2 is made to be 50 $\mu$m or less. The resin film 2 carries out the function of insulation of the soft magnetic metal layers 4 in the laminated soft magnetic member of the present invention. However, if this insulating layer becomes thick, the magnetic coupling of the soft magnetic metal layers 4 is made weak, and accordingly the permeability of the laminated soft magnetic member is lowered; thus, the thickness of the resin film is made to be 50 μm or less. The preferable thickness of the resin film 2 is 25 μm or less, and the further preferable thickness of the resin film 2 is 10 μm or less. Of course, it is difficult to produce an extremely thin resin film 2 and an extremely thin resin film 2 cannot maintain the prescribed strength for forming the soft magnetic metal layer 4. Accordingly, it is recommended that the thickness of the resin film 2 is either 0.5 μm or more or 2 μm or more.

It is preferable that the soft magnetic metal layer 4 is 1 μm or less in thickness. This is because with the thickness exceeding 1 μm, the eddy current loss becomes high in the high frequency band exceeding 800 MHz that is the target band of the present invention, and thus the function as a magnetic material is impaired. Accordingly, it is further preferable that the thickness of the soft magnetic metal layer 4 is made to be 0.5 μm or less. It is preferable that the soft magnetic metal layer 4 is densely formed, and hence it is necessary for the soft magnetic metal layer 4 to have a minimal film thickness which permits forming a dense film by means of a various types of processes. Incidentally, an oxide layer may be formed on the surface of the soft magnetic metal layer 4.

It is sufficient for the metal sublayer 3 to have a thickness of several ten nm, in consideration of the function thereof as a conductive layer in electroplating. Incidentally, an oxide layer may be present on the surface of the metal sublayer 3, namely, between the metal sublayer 3 and the soft magnetic metal layer 4. The interposition of an oxide layer which is large in electric resistance weakens the magnetic coupling between the base film and the plated film a little, but increases the electric resistance along the film cross section direction and provides an effect which reduces the eddy current. Because plating becomes difficult when the oxide layer is too thick, the oxide layer thickness is made to be 400 Å or less, preferably 300 Å or less, more preferably 200 Å or less. The oxide layer can be formed by exposing the metal sublayer 3 to the air after completion of the metal sublayer 3 formation. This is also the case for the oxide layer formed on the surface of the soft magnetic metal layer 4.

The soft magnetic sheet 11 shown in FIG. 2 is different from the soft magnetic sheet 1 shown in FIG. 1 in that soft magnetic metal layers are on both sides of a resin film 2. More specifically, the soft magnetic sheet 11 comprises the resin film 12 (a first resin film), metal sublayers 13a, 13b formed both on the front surface and on the back surface of the resin film 12, and soft magnetic metal layers 14a, 14b formed on the metal sublayers 13a, 13b. The materials, dimensions and production processes for the resin film 12, the metal sublayers 13a, 13b, and the soft magnetic metal layers 14a, 14b can be made similar to those for the soft magnetic sheet 1 described on the basis of FIG. 1.

In the above description, examples have been shown in which the resin film 2 is used as an insulating layer; however, the present invention can use a heat fusion bonded resin layer (heat fusion bonded layer) in place of the resin film 2. For the heat fusion bonded layer, for example, polyamide can be used. Additionally, a heat fusion bonded layer can be formed by a variety of methods including electrostatic coating, coating, spraying, film bonding and the like. Heat fusion bonded layers formed by coating and spraying can be made as extremely thin as 1.0 μm or less, moreover 0.5 μm or less. However, if too thin, no heat fusion bonded layer may possibly be formed on some portions so that it is preferable to make the thickness be 0.1 μm or more.

Additionally, as the insulating layer, a thermo-compression bonded resin layer (thermo-compression bonded layer) can be used. As for obtaining a thermo-compression bonded layer, for example, a PET film is used as the resin film 2, and a plurality of soft magnetic sheets 1 are laminated, then a heating/pressing is applied at a prescribed temperature and a prescribed pressure, and thus a thermo-compression bonded layer can be obtained.

Additionally, in the soft magnetic sheet 11 of the present invention, a resin layer can be formed on the soft magnetic metal layer 4. As this resin layer, the resin film 2 can be applied, and the heat fusion bonded layer can also be applied.

<Laminated soft magnetic member>

FIG. 3 is a sectional view showing one example of a laminated soft magnetic member 5 of the present embodiment.

As shown in FIG. 3, the laminated soft magnetic member 5 has a sectional structure in which insulating layers 6 and a soft magnetic metal layers 7 are alternately laminated. In this connection, it is important to make the overall thickness of the laminated soft magnetic member 5 be 0.2 mm or less. This is because, as described above, when the laminated soft magnetic member 5 is attached to a cellular phone, it is necessary to meet the size of the cellular phone. The thickness is preferably 0.15 mm or less, more preferably 0.1 mm or less.

The laminated soft magnetic member 5 can be obtained by laminating the soft magnetic sheets 1, 11 shown in FIGS. 1 and 2. In this case, the resin films 2, 12 of the soft magnetic sheets 1, 11 constitute the insulating layers 6. Accordingly, the thickness of the insulating layer 6 is made to be 50 μm or less. Of course, when an adhesive is interposed in the case where the soft magnetic sheets 1, 11 are laminated, the thicknesses of the insulating layer 6 sometimes becomes thicker than those of the resin films 2, 12. Thus, when a adhesive is used, the thicknesses of the resin layers 2, 12 are needed to be specified so that the thickness of the insulating layer 6 may be 50 µm or less. In this case, when the adhesive is made of a resin, the adhesive layers also come to constitute the insulating layers 6. Additionally, the soft magnetic metal layers 4, 14a, 14b in the soft magnetic sheets 1, 11 correspond to the soft magnetic metal layer 7. Incidentally, FIG. 3 omits the depiction of the metal sublayers 3, 13a, 13b formed in the soft magnetic sheets 1, 11. Additionally, although not shown in FIG. 3, an insulating layer 6 is provided on the uppermost, soft magnetic metal layer 7 so that the soft magnetic metal layer 7 may not be exposed on the surface. This is also the case for the following embodiments and examples.

Here, as described above, a heat fusion bonded layer can be used in place of the resin films 2, 12.

Additionally, a sticking agent or a double coated adhesive tape can be applied to either of the surfaces of the laminated soft magnetic member 5. This is for the convenience of bonding of the laminated soft magnetic member 5 to an appliance such as a cellular phone.

Additionally, in the laminated soft magnetic member 5 of the present invention, insulating layers and conductive layers can be laminated alternately on either of the surfaces thereof, in addition to the above described configuration. A laminated soft magnetic member 5 according to this form is shown in FIG. 4. As shown in FIG. 4, in addition to the configuration in which insulating layers 6 and soft magnetic metal layers 7 are alternately laminated, conductive layers 40 and insulating layers 41 can be alternately laminated. Additionally, by arranging the laminated soft magnetic member 5 in a cellular phone in such a way that the side on which the above described conductive layers 40 have been formed is arranged to the side facing the human body when the cellular phone is used, the improvement of radiation efficiency of the electromagnetic wave can be expected to a more extent. Incidentally, as the conductive layer 40, metals small in electric resistance such as Ni, Cu and Co can be used.

<Production method of the laminated soft magnetic member>

Description will be made below on the production method preferable for obtaining the laminated soft magnetic member 5 on the basis of FIGS. 5 to 8. More specifically, FIGS. 5 and 6 illustrate productionmethods for obtaining the laminated soft magnetic member 5 by use of the soft magnetic sheet 1 shown in FIG. 1; FIG. 7 illustrates a production method for obtaining the laminated soft magnetic member 5 by use of the soft magnetic sheet 11 shown in FIG. 2; and FIG. 8 illustrates a production method for obtaining the laminated soft magnetic member 5 by use of a heat fusion bonded layer as the insulating layer 6.

In FIG. 5, at the beginning, a metal sublayer 3 is formed on a resin film 2, for example, bymeans of the vacuum deposition method (FIG. 5(a)).

After the metal sublayer 3 has been formed, a soft magnetic metal layer 4 is formed on the metal sublayer 3 by means of plating or other processes, and thus the soft magnetic sheet 1 shown in FIG. 1 can be obtained (FIG. 5 (b)).

A prescribed number of the soft magnetic sheets 1 are produced, the sheets are laminated in such a way that the resin films 2 and the soft magnetic metal layers 4 of the respective soft magnetic sheets 1 are made to face each other (FIG. 5 (c) ) , and thus the laminated soft magnetic member 5 shown in FIG. 3 can be obtained.

The bonding of the soft magnetic sheets 1 can be conducted by arranging an adhesive such as epoxy resin, silicone resin and the like between the soft magnetic sheets 1. The viscosity of the adhesive is made to be 1,000 cP or less, preferably 300 cP or less, more preferably 200 cP or less. An adhesive added with a solvent is applied onto the soft magnetic sheets 1, then the solvent is allowed to evaporate to an extent such that the adhesive can maintain adhesivity, and subsequently the soft magnetic sheets 1 are laminated. Owing to the electrostatic charge in the resin films 2 composing the soft magnetic sheets 1, the lamination condition can also be maintained without using any adhesive. In this case, after the soft magnetic sheets 1 have been laminated, only the exterior circumference thereof can be subjected to adhesive bonding for the purpose of improving the adhesion strength by immersing the laminated sheets into an adhesive.

After the laminated soft magnetic member 5 has been obtained, the magnetic properties thereof can be improved by performing a stress relief annealing. The stress relief annealing, for example, for the case where an adhesive is used for the mutual bonding of the soft magnetic sheets 1, can also be conducted with concurrent heating for drying the adhesive. When the stress relief annealing is conducted, it is preferable to use for the resin film 2 polyamide resin and polyimide resin both excellent in heat resistance.

Additionally, the laminated soft magnetic member 5 can be processed into a desired shape by the warm press processing. Furthermore, the laminated soft magnetic member 5 can be processed by cutting into a desired dimension.

Next, description will be made below on FIG. 6. As described above, FIG. 6 illustrates a production method for obtaining the laminated soft magnetic member 5 by use of the soft magnetic sheet shown in FIG. 1. However, in contrast to the production method of FIG. 5, the soft magnetic sheet 1 is laminated by winding the strip-like soft magnetic sheet 1 in a toroidal shape. The partial sectional view of the winding body is shown in FIG. 6, which has the laminate structure similar to that of the laminated soft magnetic member 5 shown in FIG. 3. Now, the winding body can be used, as it is, as the laminated soft magnetic member 5, or a flat shaped laminated soft magnetic member 5 can be obtained by applying an appropriate processing such as cutting and the like. Additionally, in FIG. 6, a circular winding shape is exemplified; the soft magnetic sheet 1 has flexibility and hence a winding body, having an arbitrary sectional shape such as an elliptical shape, a rectangular shape and the like, can be easily obtained.

As above, in the present invention, the lamination of the soft magnetic sheets 1 includes the case where a laminated element is obtained by winding a strip-like soft magnetic sheet 1 in addition to the case where a plurality of independent soft magnetic sheets 1 are laminated.

Next, description will be made on the production method illustrated in FIG. 7. FIG. 7 shows a method for obtaining the laminated soft magnetic member 5 on the basis of the soft magnetic sheet 11 shown in FIG. 2.

At the beginning, metal sublayers 13a, 13b are formed both on the front surface and on the back surface of a resin film 12 (a first insulating resin film) (FIG. 7 (a)). The metal sublayers 13a, 13b can be formed by the vacuum evaporation similarly to the production method illustrated in FIG. 5.

The metal sublayers 13a, 13b are formed both on the front surface and on the back surface, and then soft magnetic metal layers 14a, 14b are formed on the metal sublayers 13a, 13b by, for example, electroplating (FIG. 7(b)). Thus the soft magnetic sheet 11 is obtained. By laminating a plurality of the soft magnetic sheets 11, the laminated soft magnetic member 5 can be obtained. However, the soft magnetic sheet 11 has a structure in which the soft magnetic metal layers 14a, 14b are exposed both on the front surface and on the back surface, and hence the soft magnetic sheet 11 cannot be laminated as it is. Accordingly, a resin film 8 (a second insulating resin film) is separately prepared, and by laminating the soft magnetic sheets 11 with the resin film 8 interposed therebetween (FIG. 7 (c)), the laminated soft magnetic member 5 is obtained.

Next, description will be made on a production method for obtaining the laminated soft magnetic member 5 by using the heat fusion bonding layer on the basis of FIG. 8.

In FIG. 8, at the beginning, a metal sublayer 3 is formed on a resin film 2, for example, by means of vacuum deposition method (FIG. 8 (a)). After themetal sublayer 3 has been formed, a soft magnetic metal layer 4 is formed on the metal sublayer 3 by means of plating or other methods (FIG. 8(b)). The processes so far described are similar to those in the production method illustrated in FIG. 5.

Next, a resin layer 9 is formed on the soft magnetic metal layer 4 for the purpose of heat fusion bonding (FIG. 8(c)). The formation of the resin layer 9 can be conducted by means of a variety of methods including coating, spraying and the like.

By peeling off and removing the resin film 2 after the resin layer 9 has been formed, a soft magnetic sheet 21 is obtained in which the metal sublayer 3, the soft magnetic metal layer 4 and the resin layer 9 are laminated (FIG. 8 (d)). The adhesion strength of the resin film 2 to the metal sublayer 3 is higher than the adhesion strength of the resin layer 9 to the soft magnetic metal layer 4, and hence the peeling off of the resin film 2 can be conducted relatively easily. A prescribed number of the soft magnetic sheets 21 are produced, the sheets are laminated in such a way that the resin films 9 and the soft magnetic metal layers 4 of the respective soft magnetic sheets 21 are made to face each other (FIG. 8(e)), and thus the laminated soft magnetic member can be obtained.

The mutual bonding of the soft magnetic sheets 21 can be performed by use of the resin layers 9. More specifically, after the lamination of the soft magnetic sheets 21 has been conducted with the resin layers 9 and the soft magnetic metal layers 4 facing each other, the resin layers 9 are fused and cured by a prescribed heat treatment, which can ensure the mutual adhesion strength between the adjacent soft magnetic sheets 21. Additionally, although FIG. 8 shows an example in which the plurality of the soft magnetic sheets 21 are produced and then laminated, needless to say it is also possible to obtain a winding body in such a way that the peeling off of the resin film 2 and the formation of the resin film 9 are conducted consecutively, and the sheet body is subjected to winding.

Incidentally, although in the above description the soft magnetic sheets 21 are bonded through heat fusion bonding of the resin layers 9, the soft magnetic sheets 21 can be bonded through thermo-compression of the resin layers 9. For instance, the soft magnetic sheets 21 can be mutually bonded with the aid of the thermo-compression bonded resin layers 9, on the basis of the selection of PET for the resin layer 9 and the application of a prescribed pressure under the condition of being heated to a temperature of about 150 to 300°C.

<Installation in a cellular phone>

The laminated soft magnetic member 5 obtained as described above can be installed in a cellular phone. Incidentally, here is exemplified a cellular phone as a portable electric appliance, which is no more than a case example of the present invention.

FIG. 9 schematically shows a way in which the laminated soft magnetic member 5 is installed in a cellular phone. A cellular phone 30 comprises a front cover 31 and a case 34, between which, a circuit board 32 is arranged. According to need, a whip antenna can be mounted on the circuit board 32. In the case 34, a built-in antenna 36 is housed, a laminated soft magnetic member 35 is installed between the circuit board 32 and the case 34 in such a way that part of the laminated soft magnetic member 35 overlaps with the built-in antenna 36. Incidentally, the installation of the laminated soft magnetic member 35 can be conducted by use of a sticking agent or a double coated adhesive tape.

Description will be made below on the present invention on the basis of the specific examples.

(Example 1)

A 4 μm thick polyamide resin film was prepared, and a Ni film was formed on the polyamide resin film (on one surface) by vacuum deposition. The thickness of the Ni film was 50 nm. The Ni film functions as a conductive base layer for forming a soft magnetic metal layer by electroplating, and itself also functions as a soft magnetic metal layer.

After deposition of Ni, a film of a soft magnetic alloy, namely, an 81wt%Ni -19wt% Fe alloy (permalloy) was formed on the Ni film by use of a plating solution described below. The condition imposed on the plating solution was such that the warm bath temperature ranged from 35 to 55°C and the pH ranged from 2.0 to 3.0. Besides, electrolysis was continued with a current density of 2 A/dm$^2$ until the plating film thickness reached 1 μm. Incidentally, an appropriate surfactant was added to the plating solution for the purpose of preventing deficiency in the plating film and reducing the surface tension of the plating solution.

| Reagent name | Chemical formula | Solution composition (g/l) |
|---|---|---|
| Nickel sulfate hexahydrate | $NiSO_4 \cdot 6H_2O$ | 150 to 450 |
| Nickel chloride hexahydrate | $NiCl_2 \cdot 6H_2O$ | 15 to 45 |
| Boric acid | $H_3BO_3$ | 10 to 40 |
| Ferrous sulfate heptahydrate | $FeSO_4 \cdot 7H_2O$ | 1 to 20 |
| Glazing agent | - | 0.1 to 2 |

As described above, a soft magnetic sheet was obtained which comprised an insulating layer comprising a 4 μm thick polyamide resin film, a base layer composed of Ni formed on the polyamide resin film, and an 81 wt% Ni - 19 wt% Fe alloy layer formed on the base layer. Incidentally, the Ni forming the base layer had a coercive force of 120 oersteds (Oe) and an anisotropicmagnetic field of 260 oersteds, and was negative in magnetostriction; and the 81 wt% Ni - 19 wt% Fe alloy layer had a coercive force of 8 oersteds (Oe) and an anisotropic magnetic field of 20 oersteds, and was positive in magnetostriction. Toroidal shape of soft magnetic sheets were obtained by blanking the soft magnetic sheet thus obtained, and were laminated in such a way that the polyamide resin film and the 81 wt% Ni - 19 wt% Fe alloy layer were made to face each other. The number of the laminated sheets was 20, and hence an about 0.1 mm thick soft magnetic member was obtained. The complex permeability of the magnetic member was measured by means of an impedance analyzer 4291ARF manufactured by Yokogawa Hewlett Packard Co., Ltd. The obtained results are shown in FIG. 10. Incidentally, in FIG. 10, μ' denotes the real part of the complex permeability and μ" denotes the imaginary part of the complex permeability.

As a comparative example, a conventional composite soft magnetic member was produced in which a soft magnetic alloy powder was dispersed in a resin, and the permeability thereof was measured in a similar manner. Incidentally the soft magnetic alloy powder was the flat shaped powder which had a composition of the 70 wt% Fe - 20 wt% Si - 10 wt% Cr alloy, a particle size of 5 to 50 μm, a particle thickness of 0.2 to 0.3 μm, and a particle length of a several ten μm. Additionally, the composite soft magnetic member was the one in which chlorinated polyethylene was used as the resin, the addition amount of the flat shaped powder was 73 wt% and the thickness was 0.25 mm. FIG. 11 shows the measurement results.

As can be seen from a comparison between FIGS. 10 and 11, the laminated soft magnetic member according to the present invention has a higher permeability μ' all over the measured frequency band as compared to the conventional composite soft magnetic member, and particularly can acquire a permeability μ' higher by 5 times or more even at $10^8$ Hz (100 MHz). This fact indicates that the laminated soft magnetic member of the present invention is a member for countermeasure against noise, excellent in high frequency properties, and is particularly preferable for the countermeasure against SAR in the cellular phone.

(Example 2)

Next, the laminated soft magnetic member according to the present invention was attached to a cellular phone as shown in FIG. 9, and the radiated electomagnetic field was measured.

A soft magnetic sheet was obtained by the processes similar to those in Example 1 except that the thickness of the 81 wt% Ni - 19 wt% Fe alloy (permalloy) as the soft magnetic alloy layer was made to be 0.5 μm and the thickness

of the resin layer 9 was made to be 9 μm. The soft magnetic sheet thus obtained was cut to the size of 30 mm × 50 mm, and the 5 cut sheets were laminated, yielding a laminated soft magnetic member according to the present invention (the present invented member). Additionally, forcomparison, amember (Comparative Member 1) in which a 4 μm thick Cu plating film was formed on the polyamide resin film used in Example 1, and a 50 μm thick silicon steel plate (Comparative Member 2) wereprepared.

The outline of the measurement conditions was as follows. In an anechoic chamber, the electromagnetic waves, transmitted from the cellular phones with the present invented member, Comparative Members 1 and 2 respectively attached to the screen sides thereof, were measured by use of a receiving antenna located in a position 3 m away from the cellular phone with respect to the receiving level of the vertically polarized wave. Incidentally, a phantom was arranged on the screen side of each of the cellular phones; each cellular phone and the phantom were rotated over 360 degrees and the radiated electromagnetic wave level (receiving level) of 1.8 GHz was measured every 5 degrees. Incidentally, similar measurements were performed for the cases where the present invented member, Comparative Members 1 and 2 were not attached (the results thus obtained were taken as the "reference"). FIG. 12 shows the results obtained.

FIG. 12 is a circular graph showing the receiving levels (dBm) at the respective positions (angles), where the cellular phones and the phantoms were arranged at the center of the circular graph. Additionally, in the circular graph of FIG. 12, the positions with the angle of zero degree corresponds to the front face of the phantom. Accordingly, in FIG. 12, the range from 0 to 180 degrees is related to the measurement results for the side where the phantom was present (the phantom side), while the range from 180 to 360 degrees is related to the measurement results for the side where the phantom was absent (the space side). In this connection, it is desirable for the improvement of radiation efficiency of the cellular phone that the receiving level for the range from 180 to 360 degrees, namely, the gain is high.

As shown in FIG. 12, the attachment of the present invented member and Comparative Members 1 and 2 improves the receiving level in the space side as compared to the reference. FIG. 13 shows a graph obtained by developing FIG. 12 for the purpose of facilitating understanding. It can be seen that the attachment of the present invented member relatively improves the receiving level by about 2 dB as compared to the reference in the range from 270 to 300 degrees. Although the attachment of Comparative Members 1 and 2 also improves the receiving level as compared to the reference, the attachment of the present invented member further improves the receiving level by about 1 dB as compared to Comparative Members 1 and 2.

As described above, it has been found that the attachment of the present invented member to a cellular phone improves the gain of the radiated electromagnetic field. Next, the effect of the laminated number of the soft magnetic sheets in the present invented member on the gain improvement was investigated. More specifically, similarly to the above description, the receiving levels were measured for the case where one sheet of the soft magnetic sheet used in the present Example was installed in a cellular phone, for the case where a three sheet laminated soft magnetic member was installed in a cellular phone, and for the case where a five sheet laminated soft magnetic member was installed in a cellular phone. FIGS. 14 and 15 show the results obtained.

From FIGS. 14 and 15, it can be seen that with increasing the laminated number of the sheets, the improvement extent of the radiation gain grows.

(Example 3)

The samples 1 to 6 of the laminated soft magnetic members shown in FIG. 16 were produced, and the radiated electromagnetic fields were measured similarly to Example 2.

Incidentally, in FIG. 16, the samples 1 to 3 were the soft magnetic members produced by the below described productionmethodA, and the samples 4 to 6 were the soft magnetic members produced by the below described production method B.

<Production method A>

A soft magnetic sheet was obtained by forming an alloy film forming a soft magnetic metal layer on a resin film forming an insulating layer by means of the vacuum evaporation method. The film thicknesses of the soft magnetic alloy layers were as described in FIG. 16. The soft magnetic sheet was laminated in the number of plies described in FIG. 16 to yield a soft magnetic member. The thicknesses of the obtained soft magnetic members were as shown in FIG. 16.

<Production method B>

A sublayer was formed in a thickness of 50 nmby electroless plating on a 9 μm thick polyamide resin film. The materials for the respective samples were as shown in FIG. 16. After a sublayer had been formed, a soft magnetic alloy layer shown in FIG. 16 was formed by electroplating on the sublayer. Thereafter, a nylon system resin was applied as the heat fusion bonded layer onto the soft magnetic alloy layer in a thickness specified in FIG. 16. Successively, by peeling off the polyimide resin film, a soft magnetic sheet was obtained in which the soft magnetic metal layers and the heat fusion bonded layers as insulating layers were laminated. Lamination of this sheet in the number of plies described in FIG. 16 yielded a soft magnetic member. Furthermore, subsequently the heat fusion bonded layers were cured by maintaining the soft magnetic member at 170°C for 30 minutes.

The radiated electromagnetic fields were measured, and the gain improvement effects in the range from 270 to 300 degrees (see Example 2) are shown in FIG. 16. Incidentally, the gain improvement effects tooka cellular phone without any installed soft magnetic member as the reference (the reference in Example 2). As shown in FIG. 16, it has been confirmed that the installation of the soft magnetic member according to the present invention in a cellular phone remarkably improves the gain of the radiated electromagnetic field on the space side.

(Example 4)

As a conductive sublayer, a 0. 2 μm thick Ni film (coercive force : 110 oersteds, anisotropic magnetic field: 270 oersteds, magnetostriction: negative) was formed on a 13 μm thick polyamide film by means of vacuum deposition. Additionally, as a conductive sublayer, a 0.2 μm thick 80 wt% Ni - Fe alloy film (coercive force : 9 oersteds, anisotropic magnetic field: 18 oersteds, magnetostriction: positive) was formed on the same type of polyamide film. A sheet body was obtained by forming a 0.2 μm thick soft magnetic metal layer (Fe-Ni layer) by plating a 26 wt% Fe - Ni alloy (coercive force : 12 oersteds, anisotropic magnetic field: 22 oersteds, magnetostriction: negative) on the conductive base layer. Subsequently, an epoxy resin was prepared in such a way that the viscosity thereof was adjusted to be about 100 cP by dilution with a solvent, and was applied onto the surface of the soft magnetic metal layer of the sheet body. Subsequently, the solvent was partially evaporated, and a laminated soft magnetic member was obtained by mutually laminating the sheet bodies in a conditionwhereviscositystillpersisted. Incidentally, the laminated soft magnetic member was the one in which only three sheets of the sheet bodies were laminated.

The complex permeabilities were measured on the two types of laminated soft magnetic members described above in a manner similar to that in Example 1. The results obtained are shown in FIG. 17. Incidentally, in FIG. 17, the expression of (Ni-Fe/Ni) refers to the case where a sheet body was used in which a 26 wt% Fe - Ni alloy was formed on a Ni base layer. Additionally, in FIG. 17, the expression of (Ni-Fe/Ni-Fe) refers to the case where a sheet body was used in which a 26 wt% Fe - Ni alloy was formed on an 80 wt% Ni - Fe alloy layer.

As compared to the case where an 80 wt% Ni - Fe deposited film was used as the conductive base layer, the μ" of the complex permeability, for the case where a Ni deposited film was used as the conductive base layer, was observed to exhibit a double-peak distribution, and tends to have a peak value on the higher frequency side. In this way, owing to the formation of the conductive sublayer by use of a material higher in coercive force than a plating film, the anisotropic magnetic field of the soft magnetic metal layer can be increased and the resonance frequency can be shifted to the higher frequency side.

Incidentally, the frequency dependency of the complex permeability of a laminated body in which three layers were laminated by use of an epoxy resin was nearly identical to the corresponding properties of the single sheet before subjected to lamination, and hence the effect of the adhesion by use of the epoxy resin on the complex permeability has been found to be negligible. A similar lamination process was studied by use of a silicone resin having a viscosity of 800 cP, and no change in the complex permeability due to the adhesion by use of the silicone resin was observed.

(Example 5)

As a conductive sublayer, a 0.1 μm thick Ni film was formed on a 13 μm thick PET film by means of evaporation. Before vacuum evaporation, the PET film was subjected to the bombardment treatment for the purpose of improving the adhesivity of the film. By plating a 20 wt% - 80 wt% Fe-Ni alloy on the film, a Fe-Ni layer was formed as a 0.2 μm thick soft magnetic metal layer to yield a sheet body. Successively, an epoxy resin was prepared in such a way that the viscosity thereof was adjusted to be about 300 cP by dilution with a solvent, and was applied onto the surface of the soft magnetic metal layer of the sheet body. Subsequently, the solvent was partially evaporated, and a laminated soft magnetic member was obtained by mutually laminating the sheet bodies in a conditionwhereviscositystillpersisted. Incidentally, the laminated soft magnetic member was the one in which only three sheets of the sheet bodies were laminated.

FIG. 18 shows the results of plotting the high-frequency side frequency (fμ'att) at which the two-step variable μ' starts to be attenuated and the frequency (fμ"peak) at which the peak of the μ" occurs against the Fe content in the Fe-Ni film, with respect to the above described laminated soft magnetic member. From FIG. 18, it can be seen that the degradation of the permeability is small and the resonance frequency is shifted to the high frequency side in the region where the Fe content is larger than 20 wt% and smaller than 80 wt%, particularly, for the composition around 60 wt% Fe - Ni. The larger the Fe content, the larger becomes the saturation magnetization and concurrently the larger becomes the electric resistance, which probably contributes to the eddy current reduction and the resonance frequency shift to the higher frequency.

A laminated soft magnetic member in which the soft magnetic metal layer was made of a 60 wt% Fe - Ni alloy was located near the display of a cellular phone and between a phantom and the cellular phone, and the receiving levels were measured on the basis of the 3m method; consequently, it was confirmed that the gain was reduced and the effect on the SAR was also satisfactory on the phantom side where a radiation efficiency improvement of about 1.8 dB was confirmed.

(Example 6)

As a conductive base layer, a 0.1 μm thick 80 wt% Ni - Fe alloy film (coercive force: 25 oersteds, anisotropic magnetic field: 36 oersteds, magnetostriction: positive) was formed on a 13 μm thick PET film by means of vacuum evaporation. Before vacuum evaporation, the PET surface was subjected to an ion-bombardment for the purpose of improving the adhesivity of the film. A sheet body was obtained by forming a Fe-Ni layer as a 0.2 μm thick soft magnetic metal layer by plating a 26 wt% Fe - Ni alloy (coercive force : 23 oersteds, anisotropic magnetic field: 41 oersteds, magnetostriction: positive) on the film. Successively, laminated soft magnetic members were obtained by trilaminar of the sheet body and applying heat bonding at two different temperatures of 160°C and 220°C for 60 seconds. Incidentally, the applied pressure was 5 MPa.

The complex magnetic permeabilities were measured on the obtained laminated soft magnetic members in a manner similar to that in Example 1. The results obtained are shown in FIG. 19. From FIG. 19, it can be seen that the heat bonding at 220°C extended the high-frequency complex permeability to the higher frequency side than the heat bonding at 160°C. The contraction of PET at a high temperature increases the magnetic elasticity energy of the soft magnetic metal layer and makes the anisotropic magnetic field larger, and accordingly enables the complex permeability to shift to the higher frequency side.

The laminated soft magnetic member subjected to the heat bonding at 220°C was located near the display of a cellular phone and between a phantom and the cellular phone, and the receiving levels were measured on the basis of the 3m method; consequently, it was confirmed that the gain was reduced on the phantom side where a radiation efficiency improvement of about 1.6 dB was confirmed.

(Example 7)

As a conductive base layer, a 0.35 μm thick Ni film (coercive force: 120 oersteds, anisotropic magnetic field: 250 oersteds, magnetostriction: negative) was formed on a 13 μm thick PET film by means of vacuum deposition. Before vacuum deposition, the PET film was subjected to a bombardment treatment for the purpose of improving the adhesivity of the film. A sheet body was obtained by forming a Fe-Ni film as a 0.25 μm thick soft magnetic metal layer by plating a 30 wt% Fe - Ni alloy (coercive force: 18 oersteds, anisotropic magnetic field: 33 oersteds, magnetostriction: positive) on the film. Incidentally, after the deposition of the Ni film, the PET film was exposed to the air for a prescribed period of time. After the formation of the Fe-Ni film, the sectional structure of the sheet body was observed by means of a transmission electron microscope. FIG. 20 shows an observed micrograph; an oxide layer of 30 to 150 angstroms was observed on the interface between the Ni and the Fe-Ni alloy.

A laminated soft magnetic member with a dimension of 50 mm × 30 mm was obtained by five ply laminating the obtained sheet body and applying heat bonding at 200°C for 60 seconds. A double coated adhesive tape was attached to the laminated soft magnetic member, which was fixed between the surface of a cellular phone and an antenna; the cellular phone was arranged in a position adjacent to a phantom in a radio wave dark room. The electromagnetic wave transmitted from the cellular phone was received on the basis of the 3m method, and consequently a radiation efficiency improvement of 1. 7 dB was observed owing to arrangement of the multilayer film.

(Example 8)

A sheet body a was obtained by vacuum depositing a 0.05 μm thick Co film 41 (coercive force : 700 oersteds, anisotropic magnetic field: 1,200 oersteds, magnetostriction: negative) on a 6 μm thick PET film 40, and by subsequently plating a 0.2 μm thick 27% Fe - Ni alloy film 42 (coercive force : 16 oersteds, anisotropic magnetic field: 30 oersteds, magnetostriction: positive) on the Co film 41. Additionally, a sheet body b was obtained by depositing a 0.033, 0.086, 0.144 or 0.277 μm thick Ni film 51 (coercive force : 130 oersteds, anisotropic magnetic field: 280 oersteds, magnetostriction: positive) on a 6 μm thick PET film 50. By use of the sheet body a and sheet body b obtained as described above, as shown in FIG. 21, three types of laminated soft magnetic members A (FIG. 21(a)) and B (FIG. 21 (b)) were obtained. Incidentally, as for the laminated soft magnetic member A, four different types of the laminated soft magnetic members A were produced which were different from each other in the thickness of the Ni film in the sheet body b.

In FIG. 21, the laminated soft magnetic member A was produced by applying a heat bonding at 200°C for 60 seconds to three sheets of the sheet body a and one sheet of the sheet body b which were in a mutually superposed condition; incidentally, the heat bonding was conducted in the condition such that a single sheet of the 6 μm thick PET film 40 was superposed on the sheet body a that was positioned at the uppermost layer, so that the Fe-Ni alloy film should not be exposed to the outside. The laminated soft magnetic member B was produced by applying heat bonding to three sheets of the sheet body a and one sheet of the 6 μm thick PET film 40 superposed on the sheet body a that was positioned at the uppermost layer, all in a mutually superposed condition.

The radiation properties were measured by respectively arranging the obtained laminated soft magnetic members A and B between the antenna of a cellular phone and a phantom. Incidentally, the laminated soft magnetic members A were arranged in such a way that the Ni film as the conductive layer faced the phantom side. The measurement results obtained are shown in FIG. 22. Incidentally, in FIG. 22, the expression of "27% Fe -Ni/Ni" refers to the laminated soft magnetic members A, and the figures in parentheses indicate the respective thicknesses of the Ni films in the sheet body b. Additionally, the expression of "27% Fe - Ni" refers to the laminated soft magnetic member B, and the expression of "Blank" means that neither the laminated soft magnetic members A nor the laminated soft magnetic member B was installed.

It was confirmed that the radiation efficiency was further improved by 0.5 dB in the laminated soft magnetic members A each involved in an arrangement in which a Ni film was interposed between the phantom and the member, as compared to the laminated soft magnetic member B.

(Example 9)

In a radio wave dark room, the positional height of a cellular phone and the positional height of a receiving antenna were both fixed at a constant value of 1.4 m, a 30 mm wide and 30 to 60 mm long laminated soft magnetic member was arranged at the feeding point of the cellular phone in such way that the member was located between the antenna and the phantom, and thus the receiving level was measured by means of the 3m method. Incidentally, the laminated soft magnetic member used was the one obtained in Example 5. Consequently, it was found that the receiving level was independent of the sheet length as far as the length of the 30 to 60 mm long multilayer films fell within the range from 30 mm to 60 mm, while when the center of mass of the sheet was located at 11 mm $\pm$ 3 mm below a feeding point of the inverted F antenna, the improvement effect of the radiation efficiency was remarkable. This position depends on the structure and arrangement of the antenna; when the laminated soft magnetic member of the present invention was located at a position separated by more than 50 mm from the feeding point, the improvement effect of the radiation efficiency became remarkably small.

Industrial Application

As described above, according to the present invention, a laminated soft magnetic member can be provided which has a high complex permeability in the high frequency band although the thickness thereof is 0.1 mm or less. The laminated soft magnetic member, for example, when it is installed at a prescribed position in a cellular phone, can improve the radiation efficiency of the electromagnetic wave on the side opposite to the head of a human body, and simultaneously can reduce the electromagnetic wave level on the side facing the head of a human body and can improve the SAR.

**Claims**

1. A laminated soft magnetic member comprising a laminated body wherein an insulating layer and a 1 μm or less thick soft magneticmetal layer are alternately laminated, and the overall thickness is 0.2 mm or less.

2. A laminated soft magnetic member according to claim 1, wherein:

   the thickness of said soft magnetic metal layer is 0.5 μm or less.

3. A laminated soft magnetic member according to claim 1, wherein:

   said soft magnetic metal layer is composed of a soft magnetic alloy in which one or more elements of Fe, Ni and Co are the main components.

**4.** A laminated soft magnetic member according to claim 1, wherein:

said insulating layer is composed of a 50 µm or less thick resin layer.

**5.** A laminated soft magnetic member according to claim 4, wherein:

said insulating layer is composed of a heat fusion bonded resin layer.

**6.** A laminated soft magnetic member according to claim 4, wherein:

said insulating layer is composed of a thermo-compression bonded resin layer.

**7.** A laminated soft magnetic member according to claim 1, wherein:

a metal sublayer is interposed between said insulating layer and said soft magnetic metal layer.

**8.** A laminated soft magnetic member according to claim 7, wherein:

the coercive force or the anisotropic magnetic field of the metal composing said metal sublayer is larger than that of said soft magnetic metal layer.

**9.** A laminated soft magnetic member according to claim 7, wherein:

an oxide layer is present on the surface of said soft magnetic metal layer or on the surface of the said metal sublayer.

**10.** A laminated soft magnetic member according to claim 1, wherein:

a conductive layer is formed on either surface of said laminated body.

**11.** A laminated soft magnetic member according to claim 10, wherein:

an insulating layer preventing said conductive layer from being exposed to the outside is formed on said conductive layer.

**12.** A soft magnetic sheet comprising of:

a 50 µm or less thick insulating resin film;
a 1 µm or less thick soft magnetic metal layer formed by plating on said insulating resin film; and
a metal sublayer, interposed between said insulating resin layer and said soft magnetic metal layer, composed of a metal larger in coercive force than the metal composing said soft magnetic metal layer.

**13.** A soft magnetic sheet according to claim 12, wherein:

said metal sublayer and said soft magnetic metal layer are formed both on the front surface and on the back surface of said insulating resin film.

**14.** A soft magnetic sheet according to claim 12, wherein:

a resin layer is formed on said soft magnetic metal layer.

**15.** The soft magnetic sheet according to claim 12, wherein:

said soft magnetic metal layer is composed of a Fe-Ni system alloy in which the Fe content is 20 to 80 wt%.

**16.** A production method of a laminated soft magnetic member comprising of:

a step (a) for producing a sheet body in which a 1 µm or less thick soft magnetic metal layer is formed on a 50 µm or less thick insulating resin film; and
a step (b) for laminating said sheet body in such a way that said insulating resin film and said soft magnetic metal layer are arranged alternately.

**17.** A production method of a laminated soft magnetic member according to claim 16, comprising of:

a step (c) for compression bonding of the laminated body obtained by said step (b) through heating said sheet body at a temperature equal to or higher than the softening temperature of said insulating resin layer.

**18.** A production method of a laminated soft magnetic member according to claim 16, wherein:

in said step (a) a strip-like said sheet body is produced; and
in said step (b) said sheet body is laminated by winding in such a way that said insulating resin film and said soft magnetic metal layer are arranged alternately.

**19.** A production method of a laminated soft magnetic member, wherein:

a step (d) for forming a 1 µm or less thick soft magnetic metal layer on a film;
a step (e) for forming, for the purpose of heat fusion bonding, a resin layer on the surface of said soft magnetic metal layer on which said film is not formed;
a step (f) for obtaining a sheet body in which said soft magnetic metal layer and said resin layer are laminated, by peeling off said film; and
a step (g) for laminating said sheet body in such a way that said soft magnetic metal layer and said resin layer are arranged alternately.

**20.** A production method of a laminated soft magnetic member, comprising of:

a step (h) for producing a plurality of sheet bodies in each of which a 1 µm or less thick soft magnetic metal layer is formed both on the front surface and on the back surface of a first 50 µm or less thick insulating resin film; and
a step (i) for laminating said plurality of said sheet bodies through the intermediary of a second insulating resin film.

## FIG. 1

## FIG. 2

# FIG. 3

# FIG. 4

# FIG. 5

(a)

(b)

(c)

EP 1 426 982 A1

# FIG. 6

# FIG. 7

(a)

13a
12
13b

(b)

11

14a
13a
12
13b
14a

(c)

11

8

11

8

11

# FIG. 8

(a)

3
2

(b)

4
3
2

(c)

9
4
3
2

(d)

21

9
4
3

(e)

21

21

21

# FIG. 9

## FIG. 10

## FIG. 11

## FIG. 12

RECEIVING LEVEL (dBm)

| | REFERENCE |
| --- | --- |
| | COMPARATIVE MEMBER 1 |
| | COMPARATIVE MEMBER 2 |
| | PRESENT INVENTED MEMBER |

# FIG. 13

EP 1 426 982 A1

## FIG. 14

RECEIVING LEVEL (dBm)

| | REFERENCE |
| | ONE SHEET |
| | THREE SHEETS |
| | FIVE SHEETS |

FIG. 15

## FIG. 16

| SAMPLE NO. | SOFT MAGNETIC METAL LAYER | | | INSULATING LAYER | | NUMBER OF LAMI-NATED SHEET | THICK-NESS ($\mu$m) | IMPRO-VEMENT OF GAIN (dB) | REMARKS |
|---|---|---|---|---|---|---|---|---|---|
| | MATERIAL | FILM FORMATION PROCESS | THICK-NESS ($\mu$m) | MATERIAL | THICK-NESS ($\mu$m) | | | | |
| 1 | 82at%Co-8at%Fe-10at%P (Co BASED AMORPHOUS) | ELECTRO PLATING | 0.3 | POLYAMIDE RESIN | 4.0 | 15 | 64.5 | 2.0 | ·PRODUCTION METHOD A |
| 2 | 75at%Fe-12at%Si-13at%B (Fe BASED AMORPHOUS) | EAVAPO-RATION | 0.3 | POLYAMIDE RESIN | 4.0 | 15 | 64.5 | 1.7 | ·PRODUCTION METHOD A |
| 3 | 76at%Fe-10at%Ti-10at%C-4at%P (Fe BASED MICROCRYSTALLINE ALLOY) | EAVAPO-RATION | 0.3 | POLYAMIDE RESIN | 7.0 | 10 | 73.0 | 1.8 | ·PRODUCTION METHOD A |
| 4 | 79wt%Ni-15.5wt%Fe-5wt%Mo-0.5wt%Mn(PC PERMALLOY) | ELECTRO PLATING | 0.5 | NYLON BASED RESIN | 0.5 | 10 | 10.0 | 1.9 | ·PRODUCTION METHOD B ·SUBLAYER; Ni ELECTROLESS PLATING |
| 5 | 55at%Ni-45at%Fe (PB PERMALLOY) | ELECTRO PLATING | 0.5 | NYLON BASED RESIN | 0.5 | 10 | 10.0 | 1.9 | ·PRODUCTION METHOD B ·SUBLAYER; Ni ELECTROLESS PLATING |
| 6 | 49wt%Fe-49wt%Co-2wt%V (PERMENDUR) | ELECTRO PLATING | 0.8 | NYLON BASED RESIN | 0.8 | 10 | 16.0 | 1.6 | ·PRODUCTION METHOD B ·SUBLAYER; Cu ELECTROLESS PLATING |

FIG. 17

FIG. 18

FIG. 19

EP 1 426 982 A1

FIG. 20

FIG. 21

(a)

(b)

FIG. 22

27wt%Fe-Ni/Ni

27wt%Fe-Ni

Blank

Legend:
—◇— 27%Fe-Ni/Ni(0.033um)
—△— 27%Fe-Ni/Ni(0.086um)
—☐— 27%Fe-Ni/Ni(0.144um)
—◇— 27%Fe-Ni/Ni(0.277um)
—◇— 27%Fe-Ni
—◇— Blank

RECEIVING LEVEL (dB)

ANGLE (degree)

## INTERNATIONAL SEARCH REPORT

International application No.

PCT/JP02/08603

**A. CLASSIFICATION OF SUBJECT MATTER**
Int.Cl⁷ H01F1/00, H01F10/16, H01Q17/00, C22C38/00, H05K9/00

According to International Patent Classification (IPC) or to both national classification and IPC

**B. FIELDS SEARCHED**

Minimum documentation searched (classification system followed by classification symbols)
Int.Cl⁷ H01F1/00, H01F10/16, H01Q17/00, C22C38/00, H05K9/00

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 7-240593 A (Nippon Telegraph And Telephone Corp.), | 1-6,12, 15-16,18 |
| Y | 12 September, 1995 (12.09.95), Full text; Figs. 1 to 15 & JP 6349637 A & JP 6349341 A & JP 7029719 A & JP 2498888 A & US 5990417 A | 7-11,13,14, 17,19,20 |
| Y | JP 2000-124654 A (Kitakawa Kogyo Kabushiki Kaisha), 28 April, 2000 (28.04.00), Full text; Figs. 1 to 3 (Family: none) | 7-9 |
| Y | JP 5-226873 A (Kansai Paint Co., Ltd.), 03 September, 1993 (03.09.93), Full text; Figs. 1 to 2 & JP 5191187 A | 9 |

☒ Further documents are listed in the continuation of Box C.　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 November, 2002 (14.11.02) | 03 December, 2002 (03.12.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

International application No.

PCT/JP02/08603

C (Continuation). DOCUMENTS CONSIDERED TO BE RELEVANT

| Category* | Citation of document, with indication, where appropriate, of the relevant passages | Relevant to claim No. |
|---|---|---|
| Y | JP 5-43567 Y2 (FDK Corp.),<br>11 June, 1993 (11.06.93),<br>Full text; Fig. 1<br>(Family: none) | 10,11 |
| Y | JP 2000-196281 A (Sony Corp.),<br>14 July, 2000 (14.07.00),<br>Full text; Figs. 1 to 2<br>(Family: none) | 13 |
| Y | JP 2001-53485 A (NTT Advanced Technology Corp.),<br>23 February, 2001 (23.02.01),<br>Full text; Figs. 1 to 8<br>(Family: none) | 14,17 |
| Y | JP 2000-348916 A (Tokin Corp.),<br>15 December, 2000 (15.12.00),<br>Full text; Figs. 1 to 3<br>(Family: none) | 19 |

Form PCT/ISA/210 (continuation of second sheet) (July 1998)